# EUROPÄISCHE PATENTSCHRIFT

(11) **EP 0 310 589 B1**
(45) Veröffentlichungstag und Bekanntmachung des Hinweises auf die Patenterteilung: **12.05.1993**
(21) Anmeldenummer: 88890162.6
(22) Anmeldetag: 23.06.1988
(51) Int. Cl.: H02B 1/26, H05K 9/00, H02B 1/24, H01F 23/00

(54) **Elektronisches Steuergerät**
Electronic control apparatus
Appareil de commande électronique

(30) Priorität: 28.09.1987 AT 2449/87
(43) Veröffentlichungstag der Anmeldung: 05.04.1989
(73) Patentinhaber: GEC ALSTHOM T&D GESELLSCHAFT m.b.H., 4020 Linz (AT)
(72) Erfinder: Wögerbauer, Johann, A-4040 Linz (AT)
(74) Vertreter: Rossboth, Werner Heinz

(56) Entgegenhaltungen:
- AT-A- 203 886
- DE-A- 3 218 627
- FR-A- 2 454 251
- FR-A- 2 566 572

## Beschreibung

Die Erfindung bezieht sich auf ein elektronisches Steuergerät mit einem Mikroprozessor-System, einer aus zwei galvanisch getrennten Teilen bestehenden Speiseeinheit, optischen Sende- und Empfangs-Dioden und einem Metallgehäuse mit Lichtleiteranschlüssen sowie elektrischen Anschlüssen für Steuer- und Meldeleitungen, insbesondere für eine Einrichtung zur Steuerung und Überwachung einer elektrischen Energieverteilungsanlage mit mehreren von einer Schaltstation aus gesteuerten und überwachten Schaltfeldern über Lichtwellenleiter, wobei die elektrischen Signale zur Steuerung und Rückmeldung an die Steuer- und Überwachungs-Einheit in der Schaltstation in den Schaltgeräteantriebskästen des jeweiligen Schaltfeldes ausgewertet werden.

Bei aus der AT-A-2038/86 bekannten Einrichtungen zur Steuerung und Überwachung von Hochspannungsschaltanlagen in Freiluft erfolgt die Umsetzung der digitalen Signale durch ein in den Schaltgeräteantriebskasten vorhandenes Mikroprozessor-System, wodurch zur Vor-Ort-Steuerung der Schaltgeräte keine zusätzlichen Steuerschränke in den Schaltfeldern erforderlich sind.
Um elektromagnetische Beeinflussungen aus den Hochspannungsgeräten sowie Störungen durch Überspannungen möglichst ausschließen zu können und die Übertragungssicherheit von Steuerbefehlen zu optimieren, sind nicht nur eine zweipolige Steuerung der Schaltfelder, für das Mikroprozessor-System eine Speiseeinheit mit Überspannungsschutzschaltung und Filterkreise vorgesehen, sondern auch eine äußere elektromagnetisch dichte Abschirmung durch ein geerdetes Metallgehäuse, welches lediglich Lichtleiteranschlüsse und als Mehrfachstecker ausgeführte elektrische Anschlüsse für Steuer- und Meldeleitungen aufweist. Prüfungen haben jedoch ergeben, daß durch diese Maßnahmen alleine die in Hochspannungsschaltanlagen erforderliche hohe Stör- und Isolationsfestigkeit nicht erreicht werden kann.
Auch wenn die elektrischen Steuer- und Meldeleitungen über Optokoppler an den gegebenenfalls vorhandenen Komparator oder direkt an das Mikroprozessor-System angeschlossen werden, kann keine ausreichende Verbesserung erzielt werden. Solche aus einer lichtemittierenden Diode und einem Photoelement bestehenden, optoelektronischen Bauelemente werden häufig zur Datenübertragung zwischen Systemen verwendet, die sich auf stark unterschiedlichem Potential befinden.

Handelsübliche Optokoppler weisen zwar eine Isolationsfestigkeit bis zu 15 kV auf, jedoch wurde durch Versuche festgestellt, daß sie bei hohen Anstiegssteilheiten der zu isolierenden Hochspannung ihre Funktion verlieren. Bei solchen in Hochspannungsschaltanlagen vorkommenden Spannungsbeanspruchungen tritt ein Effekt ein, der sich in einer Sättigung des Phototransistors im Optokoppler zeigt, ohne daß die lichtemittierende Diode angesteuert wird.

Auch durch integrierte Schirmgitter im Optokoppler konnte dieser Effekt nicht völlig ausgeschaltet werden. Auch ist es nicht gelungen, hochfrequente Spannungsbeanspruchungen relativ langer Dauer durch Filterkreise ausreichend zu dämpfen.

Aus der FR-A1-2 566 572 ist eine Steuer- und Verbindungsvorrichtung ohne Kontakte für die automatisierte Ausrüstung von Werkzeugmaschinen mit einem abschaltbaren und abnehmbaren Element bekannt. Dieses abnehmbare Element, z. B. ein Tastkopf, ist am Werkstückhalter einer Werkzeugmaschine montierbar und dient zur Vermessung des bearbeiteten Werkstückes. Um nicht Steckkontakte verwenden zu müssen, welche im Bearbeitungsbereich von Werkzeugmaschinen zu Störungen durch Verschmutzung und Korrosion neigen würden, erfolgt die Übertragung der elektrischen Energie und der elektrischen Meßdaten zwischen abnehmbarem Element und einem in der Werkzeugmaschine angeordneten Basiselement auf induktivem bzw. optischem Weg. Im Basiselement und abnehmbaren Element sind Infrarotsender und Infrarotempfangsgeräte angeordnet, so daß moduliertes Licht übertragen werden kann. Die induktive Speisung des abnehmbaren Elements erfolgt über zwei U-förmige, bewickelte Eisenkerne, wovon der eine im Basiselement und der andere im abnehmbaren Element angeordnet ist. Beide zusammen bilden bei montiertem abnehmbaren Element einen magnetischen Kreis mit Luftspalten. Die Steuer- und Verbindungsvorrichtung weist keinen Schutz gegen elektromagnetische Einflüsse auf und wäre daher für den Einsatz in der Nähe von Hochspannungsgeräten ungeeignet.

Eine ähnliche induktive Speisung weist ein aus der FR-A1-2 454 251 bekannter Lautsprecher mit modulierter Koronaentladung auf. Damit Haushaltsgeräte, z. B. Fernsehempfänger, über elektrische Leitungen durch den Lautsprecher nicht gestört werden, bestehen der Netzanschlußtrafo und der Modulationstrafo des Laufsprechers aus zwei M-förmigen, bewickelten Eisenkernen, die zusammen einen magnetischen Kreis mit Luftspalten bilden. Mit Ausnahme der einen M-förmigen, bewickelten Eisenkerne sind sämtliche Teile des Lautsprechers in einem Metallgehäuse untergebracht. Das Chassis dieses Metallgehäuses, in dessen Ebene sich die Luftspalte der Eisenkerne befinden, weist passende Ausnehmungen für die Schenkel der Eisenkerne auf. Der Lautsprecher kann somit induktiv mit elektrischer Energie versorgt werden und aus dem Metallgehäuse führen keine elektrischen Leitungen, in welchen durch den Hochfrequenzoszillator Störungen induziert werden könnten.

Aus der DE-A1-3 218 627 sind elektrisch abgeschirmte Optokoppler bekannt, bei denen der Phototransistor in einem Metallgehäuse untergebracht ist, welches zur lichtemittierenden Diode hin durch einen Transmissionsschirm abgedeckt ist. Dieser Transmissionsschirm besteht aus Glas oder einem ähnlichen lichtdurchlässigen Material, welches mit einer Indium- oder Zinn-Oxyd-Schicht beschichtet ist, die elektrisch leitend und infrarotdurchlässig ist. Solche Optokoppler sind zwar gegen elektromagnetische Einflüsse geschützt, weisen jedoch keine ausreichende Isolationsfestigkeit gegen Erde auf, um in der Nähe von Hochspannungsgeräten eingesetzt werden zu können.

Durch die mit Erde verbundene Grundplatte des Phototransistors müßte dieser nämlich der Potentialdifferenz von mind. 5 kV gegen Erde standhalten. Darüberhinaus wäre der Phototransistor bei hohen Störfrequenzen durch in seiner Grundplatte oder in den Leiterbahnen zwischen den Phototransistor entstehende Induktivitäten funktionell gefährdet. Optokoppler dieser Art sind außerdem in ihrer Herstellung relativ aufwendig und dadurch teuer und benötigen Lichtsignale höherer Lichtintensität als herkömmliche Optokoppler, weil durch den Transmissionsschirm Verluste vorhanden sind.

Durch die in der Folge aufgezeigte erfindungsgemäße Ausführung wird bezweckt, ein elektronisches Steuergerät der eingangs genannten Art zu schaffen, welches eine Isolationsfestigkeit gegen Erde und zwischen den Anschlüssen von mindestens 5 kV aufweist und für die Anordnung in einem Schaltgeräteantriebskasten eines Hochspannungsschaltgerätes geeignet ist, wobei ein Schutz gegen erhöhte elektromagnetische Einflüsse, beispielsweise 150 kV/m, und eine hohe Übertragungssicherheit von Steuerbefehlen gegeben ist.

Dies wird dadurch erreicht, daß das Metallgehäuse durch ein Metallblech mit Ausnehmungen in zwei Fächer unterteilt ist, wobei in dem einen Fach die elektrischen Anschlüsse für Steuer- und Meldeleitungen und in dem anderen Fach das Mikroprozessor-System mit Lichtleiteranschlüssen und nach außen verbindenden optischen Sende- und Empfangs-Dioden angeordnet sind, daß die Signalübertragung zwischen den beiden Fächern ausschließlich durch die Fächerinhalte verbindende optische Sende- und Empfangs-Dioden erfolgt, welche an beiden Seiten des Metallbleches mit Abstand von diesem mit den Ausnehmungen fluchtend angeordnet sind, und daß sich die galvanisch getrennten Teile der Speiseeinheit wie an sich bekannt an beiden Seiten des Metallbleches befinden.

Durch die Unterteilung in zwei Fächer ergeben sich abgeschirmte Käfige zur galvanischen Trennung des Mikroprozessor-Systems mit seiner sensiblen Logik zum störungsbehafteten Teil mit den elektrischen Anschlüssen. Die interne Signalübermittlung zwischen den beiden Käfigen erfolgt ausschließlich auf optischem Wege, wodurch sich die bekannten Vorteile der Unempfindlichkeit gegen elektromagnetische Einflüsse und bezüglich isolierender Eigenschaften ergeben. Auch bei den höchsten vorkommenden Anstiegssteilheiten der zu isolierenden Hochspannung kann der bei handelsüblichen Optokopplern beobachtete Effekt der Sättigung des Phototransistors durch die besondere Anordnung der optischen Sende- und Empfangs-Dioden in den beiden Fächern vermieden werden.

Um die Schirmwirkung zwischen den beiden Fächern noch weiter zu erhöhen, können die Ausnehmungen durch ein mit dem Metallblech elektrisch leitend verbundenes Gitter abgedeckt sein. Außerdem können dadurch eventuell auftretende Spannungsfelder abgeleitet werden.

Bevorzugterweise bestehen die optischen Sende-Dioden aus Infrarot-Sende-Dioden mit einem Lichtöffnungswinkel von etwa 10° und die optischen Empfangs-Dioden aus Infrarot-Phototransistoren.

Bei dieser Wellenlänge besitzen die Phototransistoren die höchste Quantenausbeute, welche durch den gewählten Lichtöffnungswinkel noch verstärkt werden kann. Analog-Frequenz-Umsetzer sorgen dafür, daß über die Lichtstrecke nicht nur einfache Schaltsignale umgesetzt, sondern auch digitalisierte Analogwerte übermittelt werden können.

Bei einer bevorzugten Ausführungsform ist jede die Fächerinhalte verbindende optische Sende- und Empfangs-Diode am freien Ende eines Isolierrohres angeordnet, welches mit dem Metallblech konzentrisch zu einer Ausnehmung verbunden ist.

Die Isolierrohre vermeiden nicht nur gegenseitige Beeinflussungen durch Streulicht, sondern können auch als Träger für die Sende- und Empfangs-Dioden dienen.

Um die erforderliche Isolationsfestigkeit von mindestens 5 kV sicherzustellen, sind die die Fächerinhalte verbindenden optischen Sende- und Empfangs-Dioden in einem Abstand von mindestens 10 mm vom Metallblech angeordnet.

Das Mikroprozessor-System erhält die benötigte Energie ausschließlich durch den magnetischen Fluß über die isolierten Ferritkerne, wobei die Regelkreise lediglich mittels einer Lichtstrecke optische Signale austauschen und umsetzen. Damit können auch über die Speiseeinheit keine die sensible Logik des Mikroprozessor-System gefährdende Überspannungen eindringen.

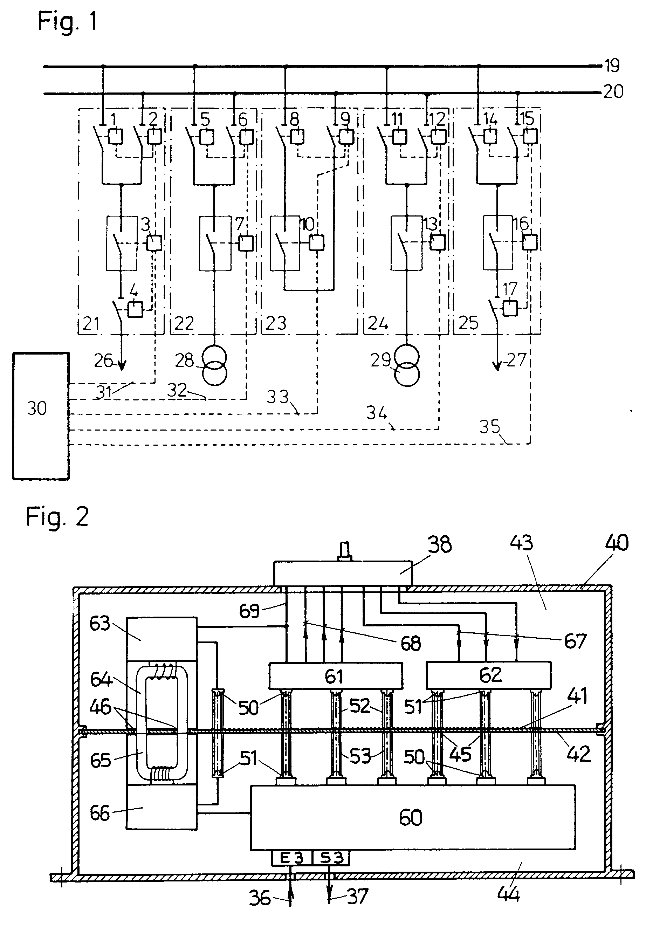

Im folgenden werden an Hand der beiliegenden Zeichnung Ausführungsbeispiele des Erfindungsgegenstandes näher erläutert. Es zeigen: Fig. 1 das einpolige Schaltbild einer fünffeldrigen Hochspannungsschaltanlage mit schematisch dargestellten Lichtwellenleiterverbindungen und Fig. 2 die Schnittdarstellung mit Blockschaltbild eines elektronischen Steuergerätes für die Schaltgeräteantriebskästen.

Aus dem in Fig. 1 dargestellten einpoligen Schaltbild einer Hochspannungsschaltanlage für Freiluft sind zwei Sammelschienen 19, 20 erkennbar, an welche je über zwei Trennschalter fünf strichpunktiert gezeichnete Schaltfelder 21 bis 25 angeschlossen sind. Im Schaltfeld 23 können die Sammelschienen 19, 20 über einen Leistungsschalter gekuppelt werden. Die Schaltfelder 22, 24 sind über Leistungsschalter je an Transformatoren 28, 29 angeschlossen und speisen die Sammelschienen 19, 20.

Zwei Schaltfelder 21, 25 führen über Leistungsschalter, Abgangstrennschalter und Leitungen 26, 27 zu Verbrauchern. Zur besseren Übersichtlichkeit des Schaltbildes sind in Fig. 1 Erdungsschalter, welche zur Personensicherheit bei Revisionen von Schaltfeldern vorgesehen sind, Meßwandler und Überspannungsableiter nicht dargestellt. Doppelte Sammelschienen 19, 20 wählt man bekanntlich aus Gründen der Versorgungssicherheit bzw. Verfügbarkeit elektrischer Energie. Sämtliche Leistungsschalter und Trennschalter sind über in Schaltgeräteantriebskästen 1 bis 17 untergebrachte Antriebe, z. B. Motor- oder Federkraftspeicher-Antriebe, Vor-Ort, von der Schaltstation oder einer Fernwirkanlage betätigbar. Zur Vermeidung von Fehlschaltungen und zum Schutz der Hochspannungsschaltanlage bei Störungen, z. B. Kurzschlüsse durch Blitzeinschläge, und Überlastungen sind Schutzmaßnahmen, beispielsweise Schaltfehlerschutz, Kurzunterbrechung, Differentialschutz u. a., vorgesehen.

Nicht nur diese Steuerfunktion, sondern auch sämtliche Melde-, Meß- und Schutzfunktionen werden in der Schaltstation von einer Steuer- und Überwachungs-Einheit 30 abgewickelt. Die Datenübertragung von der Schaltstation zu den Schaltgeräteantriebskästen 1 bis 17 und umgekehrt, gegebenenfalls von Klemmkästen an Meßwandlerrahmen, erfolgt durch bidirektionale Lichtwellenleiter 31 bis 35, welche in Fig. 1 strichliert angedeutet sind. Innerhalb eines jeden Schaltfeldes 21 bis 25 sind die Schaltgeräteantriebskästen über den Lichtwellenleiter miteinander verbunden, im Schaltfeld 21 beispielsweise die Schaltgeräteantriebskästen 1, 2, 3, 4. Vom Schaltgeräteantriebskasten 3 führt dann der Lichtwellenleiter 31 zu Steuer- und Überwachungs-Einheit 30 in der Schaltstation.

Zwischen der Steuer- und Überwachungs-Einheit 30 und den Schaltgeräteantriebskästen je eines Schaltfeldes erfolgt eine serielle Datenübertragung.

Ein Ausführungsbeispiel des elektronischen Steuergerätes für die Schaltgeräteantriebskästen 1 bis 17 gemäß Fig. 1 ist in Fig. 2 im Schnitt schematisch dargestellt.

Sämtliche Bauteile sind in einem geerdeten Metallgehäuse 40 angeordnet, welches zwei Lichtleiteranschlüsse 36, 37 und als Mehrfachstecker 38 ausgeführte elektrische Anschlüsse 67, 68, 69 aufweist. Das Metallgehäuse 40 ist durch ein eingeschobenes Metallblech 42 mit Ausnehmungen 45, welche aus Bohrungen bestehen, in zwei Fächer 43, 44 unterteilt. Diese Bohrungen sind durch ein mit dem Metallblech 42 elektrisch leitend verbundenes Gitter 41 abgedeckt. Beide Fächer 43, 44 bilden Faraday-Käfige, in welchen die elektronischen Bauteile gegen äußere Felder geschützt sind.

Über den Mehrfachstecker 38 sind drei Meldeleitungen 67 an das elektronische Steuergerät angeschlossen, welche eine elektrische Verbindung mit Stellungsmeldekontakten beispielsweise eines Hochspannungsschalterantriebes herstellen. Drei Steuerleitungen 68 führen zu Auslösespulen von Schalterantrieben und die Steuerleitung 69 ist mit einer Stromquelle, beispielsweise einer Batterie mit 220 V Gleichstrom, verbunden, welche über die Speiseeinheit 63, 64; 65, 66 nicht nur die elektronischen Bauteile 60, 61 versorgt, sondern auch für die Steuerkreise der Schalterantriebe dient.

Die Speiseeinheit besteht aus zwei galvanisch getrennten Teilen 63, 64; 65, 66, wovon der eine Teil 63, 64 im Fach 43 und der andere Teil 65, 66 im Fach 44 montiert ist. Beide Teile 63, 64; 65, 66 weisen einen U-förmigen, bewickelten Ferritkern 64; 65 auf, die zusammen einen magnetischen Kreis mit Luftspalt bilden. Die Luftspalte zwischen den Schenkeln der Ferritkerne 64; 65 befinden sich in der Ebene des Metallbleches 42. Für die Schenkel eines Ferritkernes 64 sind im Metallblech 42 passende Ausnehmungen 46 mit Spiel vorgesehen. Die Regelkreise 63, 66 sind beispielsweise zur Schaltregelung sowie Spannungsregelung der Speiseeinheit vorhanden.

Im Fach 44 ist das Mikroprozessor-System 60 mit einer Speicher- und Kontroll-Logik, der optischen Empfangs-Diode E3 und der optischen Sende-Diode S3 angeordnet, an welche die Lichtwellenleiter angeschlossen sind. Die optische Empfangs-Diode E3 ist als Photodiode mit Intrinsicschicht (PIN), die optische Sende-Diode S3 als lichtemittierende Diode (LED) für Lichtsignale mit einer Wellenlänge von vorzugsweise 820 nm ausgeführt.

Die Lichtwellenleiter führen zur Steuer- und Überwachungs-Einheit 30 gemäß Fig. 1 und bilden mit gegebenenfalls vorhandenen weiteren Schaltgeräteantriebskästen eines Schaltfeldes einen linearen Lichtwellenübertragungsweg (Bus). In den Lichtwellenleitern ist vorzugsweise eine Lichtwellenleitfaser für jede Übertragungsrichtung vorgesehen.

Das Fach 43 enthält einen Anpassungsschaltkreis 62, der mit den Meldeleitungen 67 elektrisch verbunden ist und beispielsweise einen Filterkreis zur Vermeidung von Störungen durch Meldekontaktprellungen aufweist.

Der ebenfalls im Fach 43 angeordnete Steuerschaltkreis 61 ist mit den Steuerleitungen 68, 69 elektrisch verbunden und dient zur Aufbereitung bzw. Umsetzung von digitalen Signalen aus dem Mikroprozessor-System 60 zum Einleiten von Schaltvorgängen der Hochspannungsschaltgeräte.

Damit weder über die Regelkreise 63, 66, noch über den Anpassungsschaltkreis 62 oder Steuerschaltkreis 61 die sensible Logik des Mikroprozessor-Systems 60 gefährdende Überspannungen oder elektromagnetische Felder in das Fach 44 gelangen können, erfolgt die interne Signalübermittlung zwischen den beiden Faraday-Käfigen, Fach 43, 44 des elektronischen Steuergerätes, ausschließlich auf optischem Wege.

Dazu sind an beiden Seiten des Metallbleches 42 in einem Abstand von etwa 15 mm mit den Ausnehmungen 45 jeweils fluchtend optische Sende- und Empfangs-Dioden 51, 50 angeordnet. Die optischen Sende-Dioden 51 bestehen aus Infrarot-Sende-Dioden mit einem Lichtöffnungswinkel von etwa 10°, die optischen Empfangs-Dioden 50 aus Infrarot-Phototransistoren. Vorhandene Analog-Frequenz-Umsetzer dienen zur Signalumsetzung einfacher Schaltsignale oder Übermittlung digitalisierter Analogwerte über die optischen Sende- und Empfangs-Dioden 51, 50.

Im gezeichneten Ausführungsbeispiel werden die die Fächerinhalte verbindenden optischen Sende- und Empfangs-Dioden 51, 50 jeweils von einem Isolierrohr 53, 52 getragen, welches mit dem Metallblech 42 verbunden und konzentrisch zu einer Ausnehmung 45 angeordnet ist.

Die Anwendung des elektronischen Steuergerätes ist nicht auf Hochspannungsschaltanlagen beschränkt, sondern auch bei metallgekapselten Mittelspannungsanlagen, druckgasisolierten Schaltanlagen oder der elektrischen Steuerung von Industrieprozessen auf wirtschaftliche Art einsetzbar. Das elektronische Steuergerät befindet sich dann im Steuerteil der jeweiligen Schaltzelle bzw. in den Antriebskästen oder Steuerteilen der druckgasisolierten Schaltanlage bzw. Maschine.

Prüfungen mit dem erfindungsgemäßen elektronischen Steuergerät in Hochspannungsschaltanlagen haben bewiesen, daß das Steuergerät gegen elektromagnetische Einflüsse unempfindlich ist und auch bei den höchsten in den Steuer- und Meldeleitungen 67 bis 69 vorkommenden Überspannungen einwandfrei arbeitet. Die Isolationsfestigkeit gegen Erde und zwischen den Anschlüssen beträgt mindestens 5 kV, kann jedoch durch Vergrößerung der Abstände der optischen Sende- und Empfangs-Dioden 51, 50 zum Metallblech 42, zwischen den Leiterbahnen der elektronischen Schaltkreise, Luftabstände und Verstärkung der Isolierung beliebig erhöht werden.

## Patentansprüche

1. Elektronisches Steuergerät mit einem Mikroprozessor-System (60), einer aus zwei galvanisch getrennten Teilen bestehenden Speiseeinheit (63 bis 66), optischen Sende- und Empfangs-Dioden (S3, E3) und einem Metallgehäuse (40) mit Lichtleiteranschlüssen (36, 37) sowie elektrischen Anschlüssen (38) für Steuer- und Meldeleitungen (67, 68, 69), insbesondere für eine Einrichtung zur Steuerung und Überwachung einer elektrischen Energieverteilungsanlage mit mehreren von einer Schaltstation aus gesteuerten und überwachten Schaltfeldern (21 bis 25) über Lichtwellenleiter (31 bis 35), wobei die elektrischen Signale zur Steuerung und Rückmeldung an die Steuer- und Überwachungs-Einheit (30) in der Schaltstation in den Schaltgeräteantriebskästen (1 bis 17) des jeweiligen Schaltfeldes (21 bis 25) ausgewertet werden, dadurch gekennzeichnet, daß das Metallgehäuse (40) durch ein Metallblech (42) mit Ausnehmungen (45) in zwei Fächer (43, 44) unterteilt ist, wobei in dem einen Fach (43) die elektrischen Anschlüsse (38) für Steuer- und Meldeleitungen (67 bis 69) und in dem anderen Fach (44) das Mikroprozessor-System (60) mit Lichtleiteranschlüssen (36, 37) und nach außen verbindenden optischen Sende- und Empfangs-Dioden (S3, E3) angeordnet sind, daß die Signalübertragung zwischen den beiden Fächern (43, 44) ausschließlich durch die Fächerinhalte verbindende optische Sende- und Empfangs-Dioden (51, 50) erfolgt, welche an beiden Seiten des Metallbleches (42) mit Abstand von diesem mit den Ausnehmungen (45) fluchtend angeordnet sind, und daß sich die galvanisch getrennten Teile (63, 64; 65, 66) der Speiseeinheit (63 bis 66) wie an sich bekannt an beiden Seiten des Metallbleches (42) befinden.

2. Elektronisches Steuergerät nach Anspruch 1, dadurch gekennzeichnet, daß die optischen Sende-Dioden (51) aus Infrarot-Sende-Dioden mit einem Lichtöffnungswinkel von etwa 10° bestehen.

3. Elektronisches Steuergerät nach Anspruch 1 oder 2, dadurch gekennzeichnet, daß die optischen Empfangs-Dioden (50) aus Infrarot-Phototransistoren bestehen.

4. Elektronisches Steuergerät nach einem der Ansprüche 1 bis 3, dadurch gekennzeichnet, daß jede die Fächerinhalte verbindende optische Sende- und Empfangs-Diode (51, 50) am freien Ende eines Isolierrohres (52, 53) angeordnet ist, welches mit dem Metallblech (42) konzentrisch zu einer Ausnehmung (45) verbunden ist.

5. Elektronisches Steuergerät nach einem der Ansprüche 1 bis 4, dadurch gekennzeichnet, daß die die Fächerinhalte verbindenden optischen Sende- und Empfangs-Dioden (51, 50) in einem Abstand von mindestens 10 mm vom Metallblech (42) angeordnet sind.

## Claims

1. Electronic controller having a microprocessor system (60), a supply unit (63 to 66) consisting of two electrically isolated parts, optical transmitting and receiving diodes (S3, E3) and a metal housing (40) with optical fibre connections (36, 37) as well as electrical connections (38) for control and signalling lines (67, 68, 69), especially for a device for controlling and monitoring an electrical power supply system having a plurality of switch panels (21 to 25) which are controlled and monitored from a switching station via optical waveguides (31 to 35), the electrical signals being evaluated in the switching apparatus drive boxes (1 to 17) of the respective switch panel (21 to 25), for controlling and signalling back to the control and monitoring unit (30) in the switching station, characterised in that the metal housing (40) is devided into two compartments (43, 44) by a metal sheet (42) having recesses (45), the electrical connections (38) for the control and signalling lines (67 to 69) being arranged in the one compartment (43), and the microprocessor system (60), having optical fibre connections (36, 37) and externally connecting optical transmitting and receiving diodes (S3, E3), being arranged in the other compartment (44), in that signal transmission between the two compartments (43, 44) takes place exclusively by means of the optical transmitting and receiving diodes (51, 50) connecting the compartment contents, which diodes (51, 50) are arranged aligned with the recesses (45), on both sides of the metal sheet (42), at a distance therefrom, and in that the electrically isolated parts (63, 64; 65, 66) of the supply unit (63 to 66) are located, as is known per se, on both sides of the metal sheet (42).

2. Electronic controller according to Claim 1, characterised in that the optical transmitting diodes (51) consist of infrared transmitting diodes having an aperture angle of approximately 10°.

3. Electronic controller according to Claim 1 or 2, characterised in that the optical receiving diodes (50) consist of infrared phototransistors.

4. Electronic controller according to one of Claims 1 to 3, characterised in that each of the optical transmitting and receiving diodes (51, 50) connecting the compartment contents is arranged at the free end of an insulating tube (52, 53) which is connected to the metal sheet (42) concentrically with respect to a recess (45).

5. Electronic controller according to one of Claims 1 to 4, characterised in that the optical transmitting and receiving diodes (51, 50) connecting the compartment contents are arranged at a distance of at least 10 mm from the metal sheet (42).

## Revendications

1. Poste de commande électronique avec un système à microprocesseur (60), une unité d'alimentation (63 à 66) constituée de deux parties séparées galvaniquement, des diodes d'émission et de réception (S3, E3) et un boîtier métallique (40) avec des connexions à fibres optiques (36, 37) ainsi que des connexions électriques pour des conducteurs de commande et d'ordre (67, 68, 69), en particulier pour un dispositif pour la commande et la surveillance d'une installation de distribution d'énergie électrique avec plusieurs tableaux de distribution (21 à 25), d'une station de distribution surveillée et commandée par des conducteurs d'onde optique (31 à 35), dans lequel les signaux électriques pour la commande et le retour sont évalués dans l'unité de commande et de surveillance (30) de la station de distribution dans les boîtiers de commande de distribution (1 à 17) des divers tableaux de distribution (21 à 25), caractérisé en ce que le boîtier métallique (40) est divisé par une plaque métallique (42) avec des ouvertures (45) en deux cases (43, 44), dans lequel sont disposés dans une case (43) les connexions électriques (38) pour les conducteurs de commande et de retour (67 à 69) et dans l'autre case (44) le système microprocesseur (60) avec des connexions de conducteurs de lumière (36, 37) et des diodes d'émission et de réception (S3, E3) se connectant vers l'extérieur et en ce que la transmission du signal entre les deux cases (43, 44) à lieu uniquement avec des diodes d'émission et de réception (51, 50), qui relient optiquement les contenus des cases, lesquelles sont disposées des deux côtes de la plaque métallique (42) à distance de celle-ci et affleurant contre les ouvertures (45), et en ce que les deux parties de l'unité d'alimentation (63 à 66) séparées galvaniquement (63, 64, 65, 66) se trouvent d'une façon en soi connue des deux côtés de la plaque métallique (42).

2. Appareil de commande électronique selon la revendication 1, caractérisé en ce que les diodes d'émission optique (51) sont constituées de diodes d'émission infrarouges avec un angle d'ouverture lumineuse d'environ 10°.

3. Poste de commande électronique selon l'une des revendications 1 ou 2, caractérisé en ce que les diodes de réception optique (50) sont constituées de photo-transistors infrarouges.

4. Poste de commande électronique selon l'une des revendications 1 à 3, caractérisé en ce que chacune des diodes de réception et d'émission (51, 50) reliant optiquement l'intérieur des cases sont munies à son extrémité libre d'un tube isolant (52, 53), qui est relié avec la plaque métallique (42) concentriquement à une ouverture (45).

5. Poste de commande électronique selon l'une des revendications 1 à 4, caractérisé en ce que les diodes de réception et d'émission (51, 50) reliant optiquement l'intérieur des cases sont disposées à une distance d'au moins 10 mm de la plaque métallique (42).
